# EUROPEAN PATENT APPLICATION

(11) **EP 4 174 425 A1**
(43) Date of publication of application: **03.05.2023**
(21) Application number: 21833521.4
(22) Date of filing: 29.06.2021
(51) Int. Cl.: F27B 9/04, F27B 9/26, H01L 23/12, C04B 35/587, C04B 35/64

(54) **METHOD FOR CONTINUOUSLY PRODUCING SILICON NITRIDE SINTERED COMPACT**

(30) Priority: 30.06.2020 JP 2020112366
(71) Applicant: Tokuyama Corporation, Shunan-shi, Yamaguchi 745-8648 (JP)
(72) Inventor: KUSANO, Dai, Shunan-shi, Yamaguchi 745-8648 (JP)
(74) Representative: Beckmann, Claus
(86) International application number: PCT/JP2021/024642
(87) International publication number: WO 2022/004754

(57) **Abstract**

Provided is a method for continuously producing a silicon nitride sintered compact for enabling a continuous production of silicon nitride sintered compacts by sintering using a silicon nitride powder having a high β-phase rate. A fired compact 1 housed in a firing jig 2 contains a silicon nitride powder having at least 80% of β-transition rate and 7 to 20 m²/g of specific surface area together with a sintering additive, where the total content of aluminum element is adjusted not to exceed 800 ppm. The firing jig 2 is supplied into a continuous firing furnace equipped with a closed-type firing container 5 having at its end portions a supplying openable door 3 and a discharging openable door 4 for supplying and discharging the firing jig, a heating mechanism 6 provided on the body periphery of the firing container 5, a conveyance mechanism for supplying/discharging the firing jig into/from the firing container, and a gas-supplying mechanism for supplying an inert gas into the firing container, so that the silicon nitride is heated to a temperature in the range of 1200 to 1800°C in an inert gas atmosphere and at a pressure of not less than 0 MPa·G and less than 0.1 MPa·G so as to be sintered.

## Description

### Technical Field:

The present invention relates to a method for continuously producing a silicon nitride sintered compact, for instance, a silicon nitride sintered substrate, by using a β-type silicon nitride powder.

### Background Art:

A silicon nitride sintered compact is obtained by adding any of various sintering additives to a silicon nitride powder and sintering at a high temperature. Among various ceramic sintered compacts, the silicon nitride sintered compact is advantageous in that it is lightweight, mechanically strong, chemically resistant and highly electrically-insulant, for instance, and thus, it is used for wear-resistant members such as ball bearings and high-temperature structural members. Furthermore, since the thermal conductivity can also be improved by modifying the type of the additive and sintering conditions, nowadays, the silicon nitride sintered substrate is used also as a thin and strong substrate material for heat dissipation.

It has been known that the crystal forms of silicon nitride powder includes an α-type and a β-type. For instance, as mentioned in Non-Patent Document 1, an α-type silicon nitride powder is dissolved in a sintering additive in the sintering process and re-precipitated as a β-type. As a result, a dense sintered compact with a high thermal conductivity can be obtained, and it has been widely used recently.

However, in production of the α-type silicon nitride powder, the manufacturing process tends to be complicated. For instance, in a direct nitriding process, it is necessary to nitride over a long time at a low temperature in order to prevent generation of β-type silicon nitride powder, and this may raise the production cost (Non-Patent Document 2).

In view of such backgrounds, a technique of producing a sintered compact by use of a β-type silicon nitride powder that can be produced at a relatively low cost is attracting attention. Patent Document 1 describes an invention relating to silicon nitride ceramics with a high thermal conductivity and a method for producing the same. This document shows in Examples that a silicon nitride sintered compact is obtained by preparing a compact (compact to be fired) comprising a β-type silicon nitride powder having an average particle diameter of 0.5 um and a sintering additive consisting of ytterbium oxide and silicon nitride magnesium powder, which is sintered at 1900°C for 2 to 24 hours in pressurized nitrogen of 10 atm.

### Prior art documents:

### Patent Document:

[Patent Document 1] JP 2002-128569A

### Non-Patent Document:

[Non-Patent Document 1] Journal of the Marine Engineering Society in Japan, September 1993, Volume 28, Issue 9, p548-556 [Non-Patent Document 2] Journal of the Ceramic Society of Japan 100 [11] 1366-1370 (1992)

### Summary of the invention:

### Problem to be solved by the invention:

As described above, the sintered compact of β-type silicon nitride powder is produced in pressurized nitrogen at 10 atm. In general, firing under pressure may easily inhibit or slow down decomposition of silicon nitride in the raw material, and this makes it possible to fire at a high temperature, i.e., higher than 1800°C. It has been known that firing at high temperature and high pressure can serve to densify the thus formed fired compact. Furthermore, this firing can reduce the amount of impurity oxygen that is solid-dissolved inside the silicon nitride particles. Since the impurity oxygen is a factor to degrade the thermal conductivity, the firing at high temperature and high pressure can contribute to obtain a sintered compact having high thermal conductivity. However, in a case of firing under pressure, it is necessary to use a pressure-resistant container for the production. This may limit the production method in terms of equipment. Namely, the production is usually limited to a batch process, which requires repeated temperature-rising and cooling for every batch, thereby increasing the production cost. Further, this Patent Document does not describe or suggest a method for obtaining a sintered compact having a high thermal conductivity by using the β-type silicon nitride powder and under conditions of normal pressure (atmospheric pressure) or substantially atmospheric pressure (pressure in the vicinity of atmospheric pressure) without necessity of using a pressure-resistant container.

An object of the present invention is to overcome the aforementioned problems in conventional methods, and the present invention aims to enable use of continuous firing furnace to conduct sequentially supplying/ejecting sintering materials to/from the firing furnace by using as a raw material a silicon nitride powder having a high β-phase rate and sintering it at or about normal pressure, thereby producing silicon nitride sintered compact, with favorable productivity.

### Means for Solving the Problems:

As a result of intensive studies to achieve the object, the present inventors have come to propose the present invention. That is, the inventors use a so-called β-type silicon nitride powder having a high β-phase rate. Specifically, a compact to be fired contains a silicon nitride powder having a specific surface area in a predetermined range and a sintering additive, and the total content of aluminum element is set to a specific range. The inventors have found that the compact can be fired at a normal pressure or a substantially normal pressure, which enables use of the aforementioned continuous firing furnace, thereby arriving at a method for enabling continuous production of a silicon nitride sintered compact of high quality.

Specifically, the present invention provides a method for continuously producing a silicon nitride sintered compact. The method comprises: supplying a firing jig that houses a compact to be fired into a continuous firing furnace, and applying heat to a temperature in a range of 1200 to 1800°C in an inert gas atmosphere and under pressure of not less than 0 MPa·G and less than 0.1 MPa·G so as to sinter the silicon nitride. The compact to be fired contains a silicon nitride powder having a β-phase rate of not less than 80% and a specific surface area of 7 to 20 m²/g together with a sintering additive, where total content of aluminum element is adjusted not to exceed 800 ppm. The continuous firing furnace is equipped with a closed-type firing container having at end portions a supplying openable door for supplying the firing jig and a discharging openable door for discharging the firing jig, a heating mechanism provided on the body periphery of the firing container, a conveyance mechanism for supplying/discharging the firing jig into/from the firing container, and a gas-supplying mechanism for supplying an inert gas into the firing container.

In this method, a continuous firing furnace in use comprises a heating mechanism divided into a plurality of zones in the direction for conveying the firing container, and the temperature of each zone can be adjusted independently. This is preferable since optimal sintering can be proceeded in the aforementioned firing temperature range.

Furthermore, the composition for forming the compact to be fired is composed of a silicon nitride powder, a sintering additive and an aqueous liquid like water. This can solve problems of inflammability and explosion in the continuous firing furnace, and thus, preferable to a case of preparing the composition by use of an organic solvent.

Furthermore, it is efficient that the compact to be fired is provided as plates, which are laminated and housed in the firing jig so that the compact is to be supplied/discharged into/from the continuous firing furnace.

The present invention uses a continuous firing furnace for sintering silicon nitride, and the furnace comprises: a firing jig housing a compact to be fired, the compact contains a silicon nitride powder and a sintering additive; a closed-type firing container having at end portions a supplying openable door for supplying the firing jig and a discharging openable door for discharging the firing jig; a heating mechanism provided on the body periphery of the firing container; a conveyance mechanism for supplying/discharging the firing jig into/from the firing container; and a gas-supplying mechanism for supplying an inert gas into the firing container.

### Effect of the Invention:

According to the present invention, it is possible to continuously produce, with good productivity, a silicon nitride sintered compact having excellent quality by using a silicon nitride powder having a high β-phase rate.

### Brief description of the drawings:

[Fig. 1] is a schematic view showing an embodiment of a continuous firing furnace, which is used to perform continuous firing in the present invention.
[Fig. 2] is a chart showing an example of a temperature profile for the continuous firing furnace of the present invention.

### Mode for Carrying Out the Invention:

### [Method for producing a silicon nitride sintered compact]

As described above, the method for producing a silicon nitride sintered compact of the present invention comprises: supplying a firing jig housing a compact to be fired into a continuous firing furnace; and heating to a temperature to a range of 1200 to 1800°C in an inert gas atmosphere and under pressure of not less than 0 MPa·G and less than 0.1 MPa·G (hereinafter, such a slightly increased pressure may be also included in the range of "normal pressure"), thereby sintering the silicon nitride. Here, the compact to be fired contains a silicon nitride powder having a β-phase rate of not less than 80% and a specific surface area of 7 to 20 m²/g together with a sintering additive, where the total content of aluminum element is adjusted not to exceed 800 ppm. And the continuous firing furnace comprises a closed-type firing container having at the both end portions a supplying openable door and a discharging openable door for supplying/discharging the firing jig, a heating mechanism provided on the body periphery of the firing container, a conveyance mechanism for supplying/discharging the firing jig into/from the firing container, and a gas-supplying mechanism for supplying an inert gas into the firing container.

### [Compact to be fired]

The compact to be fired in the method for producing the silicon nitride sintered compact of the present invention is explained below. The compact to be fired is a compact containing the specific silicon nitride powder and a sintering additive described below. As mentioned below, the compact to be fired may be a compact formed without using an organic binder, or a degreased compact obtained by forming using an organic binder and removing the organic binder from the obtained compact by degreasing.

### <Silicon nitride powder>

### (β-phase rate)

The β-phase rate of the silicon nitride powder contained in the compact to be fired is 80% or more. Since a silicon nitride powder having a β-phase rate of 80% or more can be obtained without setting any strict production conditions, it can be produced at a relatively low cost. That is, use of the silicon nitride powder having a high β-phase rate can reduce the overall cost for producing the silicon nitride sintered compact. Another advantage imparted by setting the high β-phase rate is that it can further reduce the amount of oxygen taken up by the α-type silicon nitride particles for transition to the β-type silicon nitride particles during the firing. Here, the β-phase rate of the silicon nitride powder is preferably 85% or more, and further preferably, 90% or more.

The β-phase rate of the silicon nitride powder means a peak intensity ratio of the β-phase relative to the sum of the α-phase and the β-phase in the silicon nitride powder [100 × (peak intensity of β-phase) / (peak intensity of α-phase + peak intensity of β-phase)], and it is determined by powder X-ray diffraction (XRD) measurement using CuKα rays. More particularly, it is determined by calculating the weight ratio of α-phase to β-phase in a silicon nitride powder by the method described in C.P. Gazzara and D.R. Messier: Am. Ceram. Soc. Bull., 56 (1977), 777-780.

### (Amount of solid solution oxygen)

Though the amount of solid solution oxygen in the silicon nitride powder is not particularly limited in the present invention, preferably it is not more than 0.2% by mass, whereby a silicon nitride sintered compact having a high thermal conductivity is obtained. The amount of solid solution oxygen in the silicon nitride powder is preferably not more than 0.1% by mass. Here, the amount of solid solution oxygen means oxygen solid-dissolved inside the particles of the silicon nitride powder (hereinafter, this will be also referred to as internal oxygen), which does not include oxygen derived from an oxide such as SiO₂ that is inevitably present on the particle surface (hereinafter, this will also be referred to as external oxygen) . The amount of the solid solution oxygen can be measured by the method described in Example.

Although there is no particular limitation on the method of adjusting the amount of solid solution oxygen in the silicon nitride powder, for instance, a high-purity material may be favorably used in producing the silicon nitride powder. For instance, in a case of producing a silicon nitride powder by a direct nitriding process, it is preferable to use a silicon powder as a raw material having no internal factor to cause solid solution of oxygen. Specifically, it is preferable to use a silicon powder derived from semiconductor-grade silicon. The silicon powder may be a cutting powder generated during a process such as silicon cutting. The semiconductor-grade silicon is typically a polycrystalline silicon obtained by a so-called "Siemens method" in which high-purity trichlorosilane is made react with hydrogen in a Belgian type reaction container.

### (Specific surface area)

The specific surface area of the silicon nitride powder is 7 to 20 m²/g. In a case where the specific surface area of the silicon nitride powder is less than 7 m²/g, it will be difficult to obtain a silicon nitride sintered compact having high density and high strength by firing at around normal pressure. As a result, it will be difficult to employ a continuous firing furnace as described later. When the specific surface area exceeds 20 m²/g, the amount of solid solution oxygen tends to increase, and the thermal conductivity of the obtained silicon nitride sintered compact may deteriorate. The specific surface area of the silicon nitride powder is preferably 12 to 15 m²/g. In the present invention, the specific surface area means a BET specific surface area measured by using a BET single point method based on nitrogen gas adsorption.

### (Average particle diameter)

The average particle diameter D50 of the silicon nitride powder is preferably 0.5 to 3 µm, more preferably 0.7 to 1.7 um. When using such a silicon nitride powder of the average particle diameter, sintering at normal pressure is more likely to proceed. The average particle diameter D50 is a value on a 50% volume basis measured by the laser diffraction scattering method. As for the silicon nitride powder, the proportion of particles having a particle diameter of not more than 0.5 um is preferably 20 to 50% by mass, and more preferably 20 to 40% by mass. And as for the silicon nitride powder, the proportion of particles having a particle diameter of not less than 1 um is preferably 20 to 50% by mass, and more preferably 20 to 40% by mass. By using a silicon nitride powder having the particle diameter distribution, it is easy to obtain a dense silicon nitride sintered compact having a high thermal conductivity by firing at normal pressure. The reason therefor is not clear. One theory has it that, unlikely to the α-type silicon nitride particles, the β-type silicon nitride particles are hardly dissolved and re-precipitated during firing. Therefore, by keeping the fine particles and the coarse particles in a constant balance in the initial stage of firing, it will be possible to obtain a denser sintered compact.

### (Total amount of oxygen)

The total amount of oxygen in the silicon nitride powder is not particularly limited, but is preferably not less than 1% by mass. The total amount of oxygen is a sum of the above-described amount of solid solution oxygen (internal oxygen) and the amount of external oxygen. When the total amount of oxygen is equal to or higher than the lower limit values, an effect is imparted, for instance, sintering is easily promoted by silicon oxide or the like on the particle surface. The total amount of oxygen in the silicon nitride powder is preferably not more than 10% by mass . Even when the total amount of oxygen in the silicon nitride powder is 1% by mass or more, it is possible to improve the thermal conductivity of the sintered compact as long as the amount of solid solution oxygen is equal to or lower than the predetermined value, as mentioned above. The total amount of oxygen in the silicon nitride powder can be measured by the method described in Example.

### <Production of silicon nitride powder>

The method for producing the silicon nitride powder is not particularly limited as long as it is a method for obtaining a silicon nitride powder having the above-described properties. Examples of the method for producing a silicon nitride powder include a reduction nitriding method, a direct nitriding method, and an imide decomposition method. In the reduction nitriding method, silicon nitride is generated from a silica powder by flowing a nitrogen gas in the presence of carbon powder. In the direct nitriding method, a silicon powder is made react with nitrogen at a high temperature. And in the imide decomposition method, silicon halide is made react with ammonia. From the viewpoint of easily producing a silicon nitride powder having the above-described properties, the direct nitriding method is preferred, and in particular, a direct nitriding method using a self-combustion method (combustion synthesis method) is further preferred. The combustion synthesis method is a method of using a silicon powder as a raw material. A part of the material powder is forcibly ignited in a nitrogen atmosphere so as to synthesize silicon nitride by self-heating of the material compound. Since the combustion synthesis method is a known method, JP 2000-264608A, WO2019/167879 and the like can be referred to for this method.

### <Sintering additive>

Though the sintering additive used in the present invention is not particularly limited as long as it can be used for sintering the silicon nitride powder, a sintering additive containing a compound having no oxygen bond is used particularly suitably. By using the sintering additive, it is possible to further prevent a degradation of thermal conductivity of the silicon nitride sintered compact even in firing at around normal pressure. Preferred examples of the compound having no oxygen bond as described above include a carbonitride-based compound containing a rare earth element or a magnesium element (hereinafter, also referred to as a specific carbonitride-based compound) and a nitride-based compound (hereinafter, also referred to as a specific nitride-based compound). By using a specific carbonitride-based compound and a specific nitride-based compound, a silicon nitride sintered compact having a higher thermal conductivity can be obtained more easily and more effectively. More specifically, it is considered that the specific carbonitride-based compound functions as a getter agent for adsorbing oxygen contained in the silicon nitride powder, and lowers the total amount of oxygen in the silicon nitride sintered compact of the specific nitride-based compound, whereby a silicon nitride sintered compact having a high thermal conductivity can be obtained.

Preferred examples of rare earth element in the carbonitride-based compound include Y (yttrium), La (lanthanum), Sm (samarium), Ce (cerium), and ytterbium (Yb).

Examples of the carbonitride-based compound containing a rare earth element include Y₂Si₄N₆C, Yb₂Si₄N₆C and Ce₂Si₄N₆C. Among them, from the viewpoint of obtaining easily a silicon nitride sintered compact having a high thermal conductivity, Y₂Si₄N₆C and Yb₂Si₄N₆C are preferred. An example of carbonitride-based compound containing a magnesium element is MgSi₄N₆C. Also, examples of specific nitride-based compounds containing a magnesium element include MgSiN₂. Any one of these specific carbonitride-based compounds and specific nitride-based compounds may be used alone, or two or more of them may be used in combination.

Among these carbonitride-based compounds containing a rare earth element or a magnesium element and specific nitride-based compounds, Y₂Si₄N₆C, MgSi₄N₆C and MgSiN₂ are the most preferred compounds.

The sintering additive may further contain a metal oxide in addition to the aforementioned compound having no oxygen bond. When the sintering additive contains a metal oxide, sintering of the silicon nitride powder is accelerated, whereby a denser and stronger sintered compact can be obtained easily. Examples of the metal oxide include yttria (Y₂O₃), magnesia (MgO), and ceria (CeO) . Among them, yttria is preferred. One of the metal oxides can be used alone or two or more of them can be used in combination.

The mass ratio of the compound having no oxygen to the metal oxide contained in the sintering additive (a compound having no oxygen / a metal oxide) is preferably 0.2 to 4, more preferably, 0.6 to 2. The representative examples of the compound having no oxygen is the compound based on the specific carbonitride. When the ratio is within the range, a dense silicon nitride sintered compact having a high thermal conductivity can be obtained easily.

The content of the sintering additive in the compact to be fired is preferably 5 to 20 parts by mass, and more preferably 7 to 10 parts by mass, relative to 100 parts by mass of the silicon nitride powder.

### <Organic binder>

In the present invention, the compact to be fired can be produced by using an organic binder. Specifically, a compact is prepared by using the organic binder, which is then degreased, whereby the compact to be fired can be obtained. Though the organic binder is not particularly limited, examples thereof include polyvinyl alcohol, polyvinyl butyral, methylcellulose, alginic acid, polyethylene glycol, carboxy methylcellulose, ethylcellulose, and acrylic resin.

The content of the organic binder in the composition to be shaped for producing the compact to be fired is preferably 1 to 30 parts by mass relative to 100 parts by mass of the silicon nitride powder, and the ratio thereof may be appropriately determined according to the shaping method.

### <Total amount of oxygen>

In the present invention, the total amount of oxygen in the compact to be fired is preferably 1 to 15% by mass. As understandable from the above description, the compact to be fired refers to a compact to be sintered. Materials such as the organic binder and a solvent that are used for producing the compact to be fired but to be removed by a process such as degreasing prior to the sintering are not included in the definition of the compact to be fired. When the total amount of oxygen in the compact to be fired exceeds 15% by mass, the thermal conductivity of the obtained silicon nitride sintered compact may deteriorate due to the influence of oxygen. When the total amount of oxygen is less than 1% by mass, sintering will be difficult to proceed. As a result, a dense silicon nitride sintered compact cannot be obtained, whereby the thermal conductivity and strength may be degraded. The total amount of oxygen of the compact to be fired is preferably 2 to 10% by mass, and more preferably 3 to 5% by mass. The total amount of oxygen can be set to a desired range by appropriately adjusting the total amount of oxygen in silicon nitride to be used, and the type of sintering additive, as well as the shaping method and the like.

### <Total content of aluminum element>

The total content (mass) of aluminum element in the compact to be fired is preferably not more than 800 ppm. That is, for the compact to be fired, which is used in the present invention, it is preferred to reduce the amount of aluminum element as much as possible so that a silicon nitride sintered compact having a high thermal conductivity can be obtained. The total content of aluminum element in the compact to be fired is preferably not more than 700 ppm, more preferably not more than 500 ppm.

### [Production of compact to be fired]

There is no particular limitation on the method for producing a compact to be fired used in the present invention, and examples thereof include a method of shaping a composition by a known shaping means. The composition used for shaping contains at least a silicon nitride powder and a sintering additive. Examples of the known shaping methods include press molding, extrusion, injection, and sheet formation (doctor blading).

From the viewpoint of easy shaping, an organic binder may be further blended into the composition to be shaped. The type of the organic binder is as described above.

The composition to be shaped may contain also a solvent from the viewpoint of easy handling, easy shaping, and the like. The solvent is not particularly limited, and examples thereof include organic solvents such as alcohols and hydrocarbons, and water. In the present invention, water is preferably used. That is, it is preferable to form a composition to be shaped, which contains a silicon nitride powder, a sintering additive and water to obtain a compact to be fired. Water is preferably used for the solvent, as it imposes less load on the environment in comparison with a case where an organic solvent is used. Another remarkable advantage is that the risk of explosion caused by evaporation of residual solvent in the firing furnace can be avoided. This is particularly favorable for safety management in industrial practice.

Usually, when water is used as the solvent to be contained in the composition to be shaped, oxygen derived from water tends to remain inside the obtained silicon nitride sintered compact, whereby the thermal conductivity tends to deteriorate. In contrast, in the present invention, a silicon nitride powder having a solid solution oxygen in an amount not more than a predetermined value is used. As a result, even if the amount of total oxygen is increased due to the water used as the solvent, a sintered compact having a high thermal conductivity can be obtained by controlling the total amount of oxygen.

### [Degreasing]

In a case of using the organic binder in formation of the compact to be fired in the present invention, usually the organic components such as the organic binder are removed from the compact in a degreasing step. Though the degreasing conditions are not particularly limited, preferably for instance, a compact shaped using an organic binder may be heated to a temperature range of 450 to 650°C in air or an inert atmosphere such as nitrogen or argon.

A degreasing furnace used in the degreasing step may be either a batch type or a continuous type. In combination with the continuous firing furnace described later, a continuous process is preferably adopted. In a specific example of the continuous process, a degreasing chamber with the adjusted gas atmosphere is equipped with a heating mechanism capable of heating the chamber to the aforementioned temperature. In the degreasing chamber, compacts mounted on degreasing jigs are allowed to pass through continuously by a known conveyance mechanism.

In a case of providing a sintered substrate from compacts shaped as plates, usually a laminate of a plurality of compacts coated with a releasing agent like a boron nitride powder is mounted on the degreasing jig for degreasing.

For efficient degreasing, the degreasing jig is suitably a plate-like jig without a peripheral wall. In order to prevent breakage at the time of transferring the compact to be fired (degreased compact) onto the firing jig for the firing as mentioned below, the degreasing jig is preferably configured by attaching a member to make a side wall so that it can be used as a firing jig. In an embodiment for instance, the plate-like jig is used as the degreasing jig, and then, it is equipped with a cylindrical member to form a side wall and used as the firing jig.

For the degreasing jig and the firing jig, any known heat-resistant materials can be used without any particular limitations as long as the materials are stable in degreasing and further firing as required. Specifically, a carbon member is suitably used.

### [Sintering method]

In the method for producing a silicon nitride sintered compact of the present invention, specific materials suitable for sintering at the normal pressure is selected so that silicon nitride can be fired at around normal pressure. Therefore, there is no necessity of producing in a pressure vessel (pressure-resistant container), and the compact to be fired is fired continuously using a continuous firing furnace to produce a silicon nitride sintered compact. This is the greatest feature of the present invention. Due to the use of such a continuous firing furnace, there is no necessity of raising the furnace's temperature from the room temperature to the firing temperature for every batch, and thus, it is possible to perform sintering with extremely low energy.

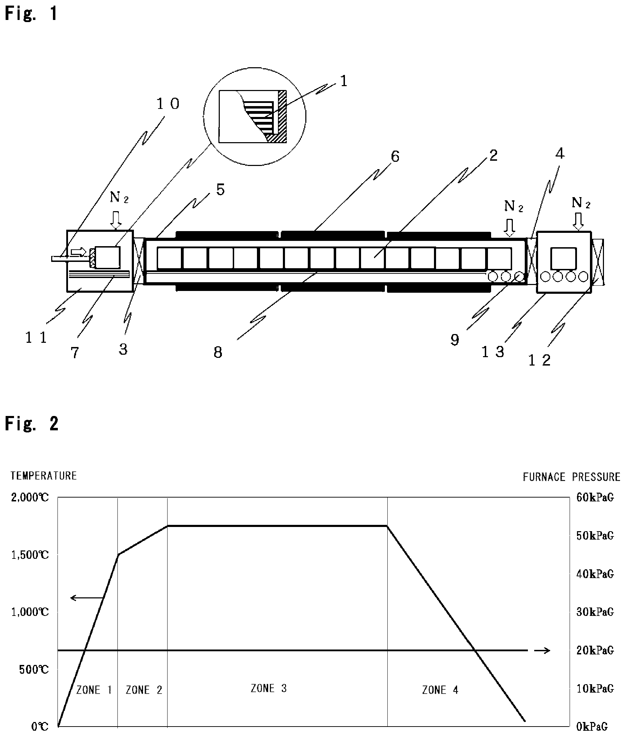

Fig. 1 is a schematic view showing an embodiment of a continuous firing furnace used for performing a continuous firing of the present invention.

As shown in Fig. 1, a firing jig 2 housing a compact 1 to be fired is supplied into a continuous firing furnace so as to fire the compact to be fired, thereby producing a silicon nitride sintered compact. Here, the continuous firing furnace comprises: a closed-type firing container 5 having at the end portions a supplying openable door 3 and a discharging openable door 4 for supplying/discharging the firing jig, a heating mechanism 6 provided on the body periphery of the firing container, a conveyance mechanism for supplying/discharging the firing jig into/from the firing container, and gas-supplying mechanism for supplying an inert gas into the firing container.

The process for performing the aforementioned firing will be explained below for an embodiment where the compact 1 to be fired to obtain a sintered compact is shaped as a plate and used as a substrate of a semiconductor device. It is efficient that a plurality of the plate-shaped compact to be fired are laminated and housed in a firing jig so as to be supplied/discharged into/from the continuous firing furnace. As mentioned above, in a case of shaping the compact to be fired by using an organic binder, it is preferable that the plates of the compact are laminated before the degreasing. Also preferably, a boron nitride powder is interposed as a releasing agent between the laminates. For the firing jig 2, a box-shaped container having a side wall, as shown in the enlarged view of Fig. 1, is suitably used. Though not shown, it is preferable that a plate-shaped sintered compact of silicon nitride is arranged at the upper and lower ends of the laminates of compact to be fired, for instance.

As for the continuous firing furnace, the firing container 5 for firing in an inert gas atmosphere does not need to be equipped with any advanced pressure-resistant structure as long as it has a structure to withstand the normal pressure.
For instance, a casing of stainless steel or the like lined with a heat-resistant member, specifically a carbon member, is suitable.

The inert gas atmosphere described above is prepared, for instance, by supplying an inert gas such as a nitrogen gas or an argon gas (hereinafter, nitrogen is referred to as an example) into the firing container 5. The pressure in the firing container is preferably adjusted to not less than 0 MPa·G and less than 0.1 MPa·G. Further preferably, the pressure is not less than 0 MPa·G and not more than 0.05 MPa·G. Here, G at the end of the pressure unit MPa·G indicates a gauge pressure .

In general, the silicon nitride is easily decomposed at normal pressure or substantially normal pressure. For this reason, it is impossible to set the firing temperature to be higher than 1800°C for instance, and thus, it is difficult to obtain a dense silicon nitride sintered compact having a high thermal conductivity. In contrast, according to the producing method of the present invention using the aforementioned specific materials for the compact to be fired, it is possible to fire at a temperature that can prevent decomposition of the silicon nitride within the aforementioned pressure range, whereby a silicon nitride sintered compact having a high thermal conductivity can be obtained.

The compact to be fired is fired by heating to a temperature in a range of 1200 to 1800°C. When the firing temperature is lower than 1200°C, sintering of the silicon nitride becomes difficult to proceed. When the temperature exceeds 1800°C, the silicon nitride will be easily decomposed. From such viewpoint, the heating temperature for firing is preferably in a range of 1600 to 1800°C.

The firing container 5 is equipped at its body portion with a heating mechanism 6 for adjusting the temperature inside the container for the firing. For the heating mechanism 6, usually a carbon heater is used. The heating mechanism 6 is preferably divided into a plurality of zones in the direction that the compact to be fired travels, and the temperature of each of the zones can be controlled independently, for the purpose of adjusting the temperature profile of the heating rate to the temperature for the firing in the firing container 5, keeping the temperature, and cooling from the temperature. In the attached drawing, the heating mechanism 6 is divided into three zones. Alternatively, for more precise temperature setting, the mechanism can be divided into four or more zones, and the mechanism can be equipped to ensure that heating temperature for each zone may be adjusted independently. The ratio of the heating time for each zone can be modified by adjusting the ratio for dividing the heating mechanism 6.

For the conveyance mechanism in the continuous firing furnace, which is used for conveying the firing jig 2 housing the compact 1 to be fired, a mechanism employed for known continuous heating furnaces may be employed without any particular limitations. Fig. 1 illustrates a pusher type conveyance mechanism that sequentially pushes the firing jig 2 from the inlet side of the firing container 5 inside the firing container 5. Specifically, it comprises a guide plate 8 and a roller 9. The guide plate 8 slides the firing jig 2 that is pushed in from the inlet side to move in the furnace, and the roller 9 having a driving section (not shown) at near the outlet side of the firing container 5 is provided to eject the firing jig 2 independently from the furnace.

Although there is no particular limitation on the firing time at the heating temperature, preferably, it is set to a range of about 3 to 20 hours at the temperature for the firing. This time period is set by adjusting the conveyance speed by the conveying means and the length or the like of the firing container.

For carrying the firing container 5 into the continuous firing furnace or carrying out therefrom, a supplying openable door 3 and a discharging openable door 4 are arranged respectively at the inlet and the outlet. The doors can be opened and closed separately. At the time of supplying or ejecting the firing jig 2 into/from the firing container 5, the supplying openable door 3 and the discharging openable door 4 open and close in conjunction with the actions of the conveyance mechanism. For the supplying openable door 3 and the discharging openable door 4, any known structures capable of ensuring airtightness in the firing container can be used without any particular limitations.

The continuous firing furnace used in the present invention is equipped with a supplying chamber 11 at the inlet side of the firing container 5. The supplying chamber 11 is partitioned from the firing container 5 by the supplying openable door 3 and provided with equipment for performing nitrogen replacement of the internal space. In the supplying chamber, a carry-in door (not shown) is opened and the firing jig is carried in. The internal space is subjected to nitrogen replacement, and its pressure is adjusted to be substantially equal to that in the firing container 5. After that, the supplying openable door 3 is opened, the firing jig 2 is pushed to be supplied into the firing container. For these operations, a piston cylinder 10 may be provided in the supplying chamber 11. Preferably, the supplying chamber 11 is equipped with the guide plate 7 having a height substantially equal to that of the conveying plane of the firing container so that the firing container 5 can be supplied smoothly into the conveying means.

At the outlet side of the firing container 5, an ejection chamber 13 is provided. The ejection chamber 13 is partitioned from the firing container 5 by the discharging openable door 4, and provided with equipment for performing nitrogen replacement of the internal space. In ejecting the firing jig from the firing container 5, the internal space of the ejection chamber 13 is subjected to nitrogen replacement, the pressure is adjusted to be substantially equal to that in the firing container 5. Then, the discharging openable door 4 is opened to perform operations for ejecting the firing jig 2 to the ejection chamber 13. After that, the discharging openable door 4 is closed, the ejection door 12 is opened to eject the silicon nitride fired compact together with the firing jig from the ejection chamber 13. The aforementioned supplying/discharging of the firing jig 2 into/from the firing container 5 is preferably performed in conjunction so that a predetermined number of firing jigs 2 remain in the firing container.

In this manner, it is possible to continuously fire the silicon nitride sintered compacts by use of the continuous firing furnace.

In the method of the present invention, the degreasing step and the post-treatment step after firing can be performed continuously by connecting to the continuous firing furnace.

### [Physical properties of silicon nitride sintered compact]

According to the method of the present invention for continuously producing silicon nitride sintered compacts, excellent silicon nitride sintered compacts comparable to what produced using a conventional batch process can be produced. By applying the aforementioned preferable conditions, a further advanced thermal conductivity can be exhibited. For instance, it is possible to obtain a silicon nitride sintered compact having a thermal conductivity of not less than 80 W/mK, or in particular, not less than 100 W/mK. Further, its dielectric breakdown voltage can be set to not less than 11 kV, or in particular, not less than 13 kV. In a silicon nitride sintered compact having the dielectric breakdown voltage, dielectric breakdown is less likely to occur, and thus, the compact imparts excellent reliability when used as a substrate for semiconductor.

The thermal conductivity, the dielectric breakdown voltage and the like are measured after blasting the surface of the silicon nitride sintered compact so as to remove deposits such as releasing agents adhering to the sintered compact during the sintering.

### Example:

Hereinafter, Example will be described to further specify the present invention, though the present invention is not limited to this Example. In Example, respective physical properties are measured by the following methods.

(1) β-phase rate of silicon nitride powder
   The β-phase rate of the silicon nitride powder was determined by powder X-ray diffraction (XRD) measurement using CuKα rays. Specifically, the weight ratio of the α-phase to the β-phase in the silicon nitride powder was calculated by the method described in C.P. Gazzara and D.R. Messier: Am. Ceram. Soc. Bull., 56 (1977), 777-780, thereby determining the β-phase rate.
(2) Specific surface area of silicon nitride powder
   The specific surface area of the silicon nitride powder was measured using a BET specific surface area analyzer (Macsorb HMmodel-1201) manufactured by Mountech Co., Ltd., according to a BET single point method by nitrogen gas adsorption. Before performing the specific surface area measurement described above, the silicon nitride powder as the measurement target was subjected to a heat treatment in air at 600°C for 30 minutes so as to remove organic matters adsorbed on the powder surface.
(3) Amount of solid solution oxygen and amount of total oxygen in silicon nitride powder
   The amount of solid solution oxygen in the silicon nitride powder was measured by the inert gas fusion-infrared absorptiometry. In the measurement, an oxygen/nitrogen analyzer ("EMGA-920" manufactured by HORIBA) was used. For the sample, 25 mg of silicon nitride powder used in Example or Comparative Example was encapsulated in tin capsules (TinCupsule manufactured by LECO was used therefor), which was introduced into a graphite crucible, and heated for 20 seconds at 5.5 kW. After degassing the adsorbed gas, the temperature was raised in 10 seconds at 0.8 kW, and in 350 seconds from 0.8 kW to 4 kW. The amount of carbon dioxide generated during the period was measured, and then, the measured value was converted into an oxygen content. During the temperature rise in 350 seconds, the oxygen generated at the early stage corresponds to oxygen derived from an oxide present on the surface of the silicon nitride particles (external oxygen), while oxygen generated later corresponds to solid solution oxygen (internal oxygen) solid-dissolved in the crystal of the silicon nitride. In light of this, a vertical line was drawn from the portion corresponding to the trough of the two measured peaks after subtracting the previously measured background, thereby separating the two peaks. By proportionally distributing the respective peak areas, the amount of solid solution oxygen (internal oxygen) and the amount of external oxygen were calculated.
(4) Particle diameter of silicon nitride powder
   (i) Pretreatment of sample
      For a pretreatment of the silicon nitride powder as a sample, the silicon nitride powder was fired for two hours at a temperature of about 500°C in air. The silicon nitride powder was imparted with hydrophilicity by the firing, and thus, it becomes easily dispersible in an aqueous solvent, allowing the measurement of particle diameter with high reproducibility. It has been confirmed that there is substantially no influence on the particle diameter to be measured even if the powder is fired in air.
   (ii) Measurement of particle diameter
      Into a beaker (60 mmϕ in inner diameter and 70 mm in height) having a marked line of maximum 100 mL, 90 mL of water and 5 mL of sodium pyrophosphate having a concentration of 5% by mass were charged and stirred well. Then, a silicon nitride powder as a sample in an amount of approximately 0.1 g was introduced and dispersed by an ultrasonic homogenizer (US-300E manufactured by NIHONSEIKI KAISHA LTD., chip diameter: 26 mm) at an amplitude of 50% (about 2 amperes) for 2 minutes. In the dispersion, the chip was inserted into the beaker so that the tip end was positioned at the marked line of 20 mL. Next, for the obtained dispersion liquid of the silicon nitride powder, particle size distribution was measured using a laser diffraction-scattering particle size analyzer (Microtrac MT3300EXII manufactured by MicrotracBEL Corp.). As for the measurement conditions, water (refractive index: 1.33) was selected as the solvent. As for the particles, the refractive index was 2.01, and the particles were permeable and non-spherical. The particle size at which the cumulative curve of the particle size distribution measured by the aforementioned particle diameter distribution measurement becomes 50% is defined as the average particle size (average particle diameter: D50).
(5) Total oxygen amount in compact to be fired
   The total amount of oxygen in the compact to be fired was measured by an inert gas fusion-infrared absorptiometry. In the measurement, an oxygen-nitrogen analyzer ("EMGA-920" manufactured by HORIBA) was used. For the sample, 15 mg of the compact to be fired was encapsulated in tin capsules (TinCupsule manufactured by LECO was used therefor) and introduced into a graphite crucible so as to be heated at 5.5 kW for 20 seconds. This was further heated at 5.0 kW for 20 seconds for degassing the adsorbed gas. Later, it was heated at 5.0 kW for 75 seconds to measure the amount of carbon dioxide generated during the heating, and the amount was converted into an oxygen content.
(6) Density of compact to be fired
   The density for each compact to be fired was measured using an automatic hydrometer (DMA-220H model manufactured by SHINKO DENSHI CO., LTD.), and the average of fifteen pieces was determined as the density of the compact to be fired.
(7) Total content of aluminum element in compact to be fired
   The total content of aluminum element in the compact to be fired was measured using an inductively coupled plasma-optical emission spectrometer ("iCAP6500DUO" manufactured by Thermo Fisher Scientific Incorporated).
(8) Thermal conductivity of silicon nitride sintered compact
   The thermal conductivity of the silicon nitride sintered compact was measured by a laser flash analysis using a LFA-502 manufactured by KYOTO ELECTRONICS MANUFACTURING CO., LTD. A thermal conductivity is determined by multiplication of the thermal diffusivity, the sintered compact density, and the specific heat of the sintered compact. For the specific heat of the silicon nitride sintered compact, a value of 0.68 (J/g·K) was employed. Density of the sintered compact was measured using an automatic hydrometer (DMA-220H model manufactured by SHINKO DENSHI CO., LTD.). Before the measurement of the thermal conductivity, the surface of the silicon nitride sintered compact was blasted and coated with Au and carbon.
(9) Dielectric breakdown voltage of silicon nitride sintered compact
   The dielectric breakdown voltage was measured according to JISC2110. Specifically, using a dielectric strength measuring device ("TK-O-20K" manufactured by KEISOKU GIKEN Co., Ltd.), voltage was applied to the silicon nitride sintered compact, thereby measuring the voltage at the time the dielectric breakdown occurred.
(10) Ra (arithmetic average roughness) of silicon nitride sintered compact
   In measurement of Ra of the silicon nitride sintered compact, a surface roughness measuring instrument ("Surfcom 480A" manufactured by TOKYO SEIMITSU CO., LTD.) was used. Scanning was performed with a probe at the evaluation length of 2.5 mm, and at a measurement degree of 0.3 mm/s. Here, the silicon nitride sintered compact was subjected in advance to surface blasting for removing the releasing agent or the like.

### <Silicon nitride powder>

A silicon powder (semiconductor-grade, average particle diameter: 5 pm) and a silicon nitride powder (average particle diameter: 1.5 um) as a diluent were mixed to obtain a raw material powder (Si: 80% by mass, Si₃N₄: 20% by mass) . The raw material powder was filled in a reaction container so as to form a raw material powder layer. Next, the reaction container was placed in a pressure-resistant closed-type reactor equipped with an igniter and a gas-supplying/discharging mechanism. After degassing inside the reactor by reducing the pressure, a nitrogen gas was supplied therein, and nitrogen replacement was conducted. Later, the nitrogen gas was gradually supplied to raise the pressure to 0.7 MPa. At the time a predetermined pressure was achieved (at the time of ignition), the bulk density of the raw material powder was 0.5 g/cm³. Thereafter, the end portion of the raw material powder in the reaction container was ignited for performing a combustion synthesis reaction to obtain clumps of silicon nitride. The obtained clumps were crushed by rubbing against each other. Then, a certain amount thereof was introduced into a vibration mill for performing fine pulverization for 6 hours. A conventional apparatus and a conventional method were employed as the pulverizer and the method for the fine pulverization. For prevention of heavy metal pollution, the interior of the pulverizer was lined with urethane, and balls based on silicon nitride was used for the pulverization media. Immediately before the start of fine pulverization, 1% by mass of ethanol as a grinding aid was added, and fine pulverization was performed in a closely-sealed pulverizer to obtain a silicon nitride powder having the following features.

| | |
|---|---|
| • β-phase rate | 99% |
| • Solid solution oxygen amount | 0.06% by mass |
| • Specific surface area | 13.5 m²/g |
| • Total oxygen amount | 1.84% by mass |
| • Average particle diameter: D50 | 1.2 um |
| • Rate of particles of not more than 0.5 um | 25% by mass |
| • Rate of particles of not less than 1.0 um | 32% by mass |

### <Sintering additive>

For preparing a compound Y₂Si₄N₆C powder having no oxygen bond, yttria (manufactured by Shin-Etsu Chemical Co., Ltd.), a silicon nitride powder (above-described powder manufactured by the present Applicant) and a carbon powder (manufactured by Mitsubishi Chemical Corporation) were synthesized with heat in accordance with the following reaction formula.

8Si₃N₄+6Y₂O₃+15C+2N₂ → 6Y₂Si₄N₆C+9CO₂

For preparing a compound MgSiN₂ powder having no oxygen bond, a magnesium powder (Yamaishi Metal Co., Ltd.), a silicon nitride powder (above-described powder manufactured by the present Applicant) and a metal silicon powder (a product possessed by the present Applicant) were synthesized with heat in accordance with the following reaction formula.

Si₃N₄+Si+4Mg+2N₂ → 4MgSiN₂

### <Organic binder>

For an organic binder, a polyvinyl alcohol resin (JAPAN VAM·POVAL CO., LTD.) was used.

### [Example 1]

100 parts by mass of silicon nitride powder, 2 parts by mass of Y₂Si₄N₆C containing no oxygen bond, 5 parts by mass of MgSiN₂, and 3 parts by mass of yttria were weighed. These materials were pulverized and mixed for 24 hours in water as a dispersion medium in a ball mill using a resin pot and silicon nitride balls . The water, which was previously weighed so that the concentration of the slurry would be 60 % by mass, was introduced into the resin pot. After the pulverization and mixing, 22 parts by mass of polyvinyl alcohol resin was added, and further mixing was performed for 12 hours to obtain a slurry-like composition to be shaped. Subsequently, the composition to be shaped was subjected to viscosity adjustment using a vacuum defoaming machine (manufactured by Sayama Riken) to prepare a slurry for coating. Thereafter, the viscosity-adjusted composition to be shaped was shaped into a sheet by doctor blading to obtain a sheet-shaped article having a width of 75 cm and a thickness of 0.42 mm. Ten sheets obtained in this manner were placed on the plate-like jig by applying a releasing agent made of a boron nitride powder, and this was set in a degreasing furnace to perform a degreasing treatment, whereby a compact to be fired was obtained. The degreasing treatment was carried out in dry air at 550°C in a batch process.

The total content of aluminum element in the obtained compact to be fired was 500 ppm. Next, a square-tubular compact of carbon was attached to the plate-like carbon jig housing the compact to be fired placed thereon, and set so as to surround the periphery as shown in the enlarged view in Fig. 1.

Jigs housing the compacts to be fired were produced sequentially, which were supplied into the continuous firing furnace shown in Fig. 1 to perform continuous firing.

The continuous firing furnace used here was equipped with a heating mechanism 6. The heating mechanism 6 was divided into four zones and placed on the body portion of the firing container 5. In order to obtain the firing profile as shown in Fig. 2, the temperature setting for each zone was programmed in accordance with the conveyance speed. Nitrogen was supplied into the firing container 5, and the pressure was adjusted to 0.02 MPa·G. The compact to be fired, which was placed on the firing jig 2, was carried into the supplying chamber by opening a carry-in door (not shown) of the supplying chamber 11. After closing the carry-in door, the internal space was subjected to nitrogen replacement, and its pressure was adjusted to be substantially equal to that inside the firing container 5. Thereafter, the supplying openable door 3 was got open and the firing jig 2 was pushed by a piston cylinder 10 so that it was supplied into the firing container 5.

By repeating the aforementioned operations, the firing jigs travel sequentially in the firing container 5. During the travel, heat was applied to achieve the temperature profile (total required time: 24 hours) as shown in Fig. 2 by controlling the temperature of the each zone in addition to setting of the length of the firing container 5, the number of the divided zones of the heating mechanism 6, and the length of each zone.

For the firing jig 2 after completion of the firing, the internal space of the ejection chamber 13 was subjected to nitrogen replacement. And after adjusting the pressure to be substantially equal to that inside the firing container 5, the discharging openable door 4 was opened, and the firing jig 2 was transferred into the ejection chamber 13. After that, the discharging openable door 4 was closed, and the ejection door 12 was opened to eject the silicon nitride fired compact in the firing jig, from the ejection chamber 13.

For measuring physical properties of the sintered silicon nitride obtained as above, 100 sheets were extracted from the continuously manufactured 1,000 sheets. Averages of the measurement values are as follows. The relative density: 99%, the thermal coefficient: 108 W/mK, the surface roughness Ra: 0.57 um, and the dielectric breakdown voltage: 16 kV. This result shows that it is possible to produce continuously silicon nitride sintered compacts that are sufficiently durable for practical use.

### Explanations of Letters or Numerals:

- 1: Compact to be fired
- 2: Firing jig
- 3: Supplying openable door
- 4: Discharging openable door
- 5: Firing container
- 6: Heating mechanism
- 7: Guide plate
- 8: Guide plate
- 9: Roller
- 10: Piston cylinder
- 11: Supplying chamber
- 12: Ejection door
- 13: Ejection chamber

## Claims

1. A method for continuously producing a silicon nitride sintered compact, the method comprising:
supplying a firing jig that houses a compact to be fired into a continuous firing furnace, and
applying heat to a temperature in a range of 1200 to 1800°C in an inert gas atmosphere and at a pressure of not less than 0 MPa·G and less than 0.1 MPa·G so as to sinter the silicon nitride,
the compact to be fired contains a silicon nitride powder having a β-phase rate of not less than 80% and a specific surface area of 7 to 20 m²/g together with a sintering additive, where total content of aluminum element is adjusted not to exceed 800 ppm; and
the continuous firing furnace is equipped with a closed-type firing container having at end portions a supplying openable door for supplying the firing jig and a discharging openable door for discharging the firing jig, a heating mechanism provided on the body periphery of the firing container, a conveyance mechanism for supplying/discharging the firing jig into/from the firing container, and a gas-supplying mechanism for supplying an inert gas into the firing container.

2. The method for continuously producing a silicon nitride sintered compact according to claim 1, wherein the heating mechanism is divided into a plurality of zones in the direction for conveying the firing container, and the heating temperature for each zone is allowed to be adjusted independently.

3. The method for continuously producing a silicon nitride sintered compact according to claim 1 or 2, wherein the compact to be fired is prepared by shaping from a composition comprising the silicon nitride powder, the sintering additive and water.

4. The method for continuously producing a silicon nitride sintered compact according to any one of claims 1 to 3, wherein the compact to be fired is shaped as plates, which are laminated and housed in the firing jig.

5. A continuous firing furnace for sintering silicon nitride, comprising:
a firing jig housing a compact to be fired, the compact contains a silicon nitride powder and a sintering additive,
a closed-type firing container having at end portions a supplying openable door for supplying the firing jig and a discharging openable door for discharging the firing jig,
a heating mechanism provided on the body periphery of the firing container,
a conveyance mechanism for supplying/discharging the firing jig into/from the firing container, and
a gas-supplying mechanism for supplying an inert gas into the firing container.
